# FASCICULE DE BREVET EUROPEEN

(11) **EP 3 532 652 B1**
(45) Date de publication et mention de la délivrance du brevet: **16.03.2022**
(21) Numéro de dépôt: 17792127.7
(22) Date de dépôt: 16.10.2017
(51) Int. Cl.: C23C 16/455, C23C 16/54, H01J 37/32

(54) **INSTALLATION DE TRAITEMENT DE SURFACE D'UN SUBSTRAT EN MOUVEMENT SOUS ATMOSPHERE CONTROLEE, ET SON PROCEDE DE DIMENSIONNEMENT**
ANLAGE ZUR BEHANDLUNG DER OBERFLÄCHE EINES BEWEGLICHEN SUBSTRATS IN EINER KONTROLLIERTEN ATMOSPHÄRE SOWIE VERFAHREN ZUR BESTIMMUNG DER GRÖSSE DAVON
FACILITY FOR TREATING THE SURFACE OF A MOVING SUBSTRATE IN A CONTROLLED ATMOSPHERE, AND METHOD FOR DEFINING THE SIZE THEREOF

(30) Priorité: 27.10.2016 FR 1660427; 22.05.2017 FR 1754494
(43) Date de publication de la demande: 04.09.2019
(73) Titulaire: Coating Plasma Innovation, 13710 Fuveau (FR)
(72) Inventeur: VALLADE, Julien, 13530 Trets (FR); PFISTER, Cédric, 13790 Rousset (FR)
(74) Mandataire: Schmidt, Martin Peter
(86) Numéro de dépôt international: PCT/FR2017/052827
(87) Numéro de publication internationale: WO 2018/078237

(56) Documents cités:
- EP-A1- 2 298 956
- FR-A1- 3 035 122
- US-A1- 2014 208 565

## Description

### Domaine technique de l'invention

L'invention concerne une installation de traitement de surface d'un substrat en mouvement, destinée à être mise en oeuvre sous atmosphère contrôlée. Elle vise par exemple une telle installation dans laquelle le substrat est soumis à un plasma généré dans un mélange gazeux, ce qui conduit à la modification de l'état de surface de ce substrat et/ou à la formation d'un dépôt sur la surface précitée. L'invention concerne en particulier une telle installation, qui peut être mise en œuvre à une pression proche de la pression atmosphérique, et qui est appropriée pour le traitement de surface continu de films polymère en bobines (procédé de type « roll-to-roll »).

### Etat de la technique

L'installation de traitement de surface au sens de l'invention comprend notamment des moyens d'injection d'un gaz de traitement, ainsi que des moyens de transformation de la surface du substrat en mouvement. Dans le cas où l'installation utilise un traitement plasma, le gaz de traitement comprend notamment un gaz plasmagène, alors que les moyens de transformation comprennent des électrodes, aptes à générer une décharge électrique. Dans le cas où l'installation utilise un rayonnement ultra-violet visible pour réticuler des résines photosensibles, le gaz de traitement est un gaz d'inertage, alors que les moyens de transformation comprennent des moyens de réticulation de la résine, coopérant avec des moyens de distribution de ces résines à la surface du substrat.

On connaît déjà des installations, visant à modifier et à améliorer les propriétés de surface d'un substrat au moyen d'un plasma. De telles propriétés d'intérêt peuvent être, par exemple, l'énergie de surface ou encore les propriétés d'adhésion de ce substrat. Les substrats visés par l'invention peuvent être notamment des isolants tels que des films polymères, des films métalliques, du papier ou du tissu.

Dans la mise en œuvre de ces installations connues, en vue du dépôt d'une couche solide mince sur la surface d'un substrat, cette surface est soumise à un plasma créé par une décharge électrique dans un gaz. Par ailleurs, simultanément ou postérieurement, le substrat ainsi traité est exposé à un mélange gazeux qui contient un composé gazeux actif, susceptible d'induire le dépôt de ce film solide mince.

Il est également connu de mettre en œuvre de manière continue des procédés de traitement d'un substrat au moyen d'une décharge électrique dans un mélange gazeux, dans lesquels le substrat est mis en mouvement à des vitesses pouvant aller jusqu'à plusieurs centaines de mètres par minute, typiquement au sein d'une chambre. Cette dernière contient, outre les électrodes nécessaires à la création de la décharge, un dispositif d'injection du mélange gazeux actif, ainsi que des moyens d'évacuation des effluents gazeux.

L'invention vise plus particulièrement, mais non exclusivement, une installation de traitement par plasma, notamment une telle installation qui opère sensiblement à pression atmosphérique. Dans ce type d'installations, le contrôle de la composition de l'atmosphère dans la zone plasma est critique pour l'efficacité du traitement. Pour ce faire dans les procédés roll-to-roll, de grandes quantités de gaz plasmagène sont injectées dans la zone de traitement pour évacuer l'air et maintenir un niveau d'oxygène bas, typiquement inférieure à 50 ppm (parties par million). Cependant, le substrat qui défile dans la zone plasma entraine avec lui une certaine quantité d'air dans une couche au voisinage de la surface appelée "couche limite". L'entrée dans la zone plasma de cet air et, en particulier de l'oxygène que contient ce dernier, a tendance à perturber le bon fonctionnement du traitement.

Afin de remédier à cet inconvénient, FR-A-2 816 726 a proposé une installation du type ci-dessus, qui est munie d'unités auxiliaires permettant d'éviter respectivement l'entrée d'air dans la chambre, ainsi que la sortie du mélange gazeux hors de cette chambre. Chaque unité auxiliaire comprend une fente d'injection d'azote permettant la création, en service, de "couteaux" gazeux. Des moyens sont en outre prévus afin de réguler les débits gazeux, de façon à maintenir une différence de pressions proche de zéro entre l'intérieur de la chambre et l'atmosphère extérieure.

Cependant, le procédé décrit dans FR-A-2 816 726 implique certains inconvénients. Tout d'abord il fait appel à des couteaux gazeux qui impliquent une consommation particulièrement élevée d'azote. De plus, le pilotage des conditions à l'intérieur de la chambre est relativement complexe à mettre en œuvre. En particulier, la pression à l'intérieur de la chambre est difficile à réguler de manière stable et reproductible. En d'autres termes, cette pression est sujette à des variations sensibles, qui ne sont pas favorables au bon pilotage de ce procédé. Enfin l'installation décrite dans FR-A-2 816 726, permettant la mise en œuvre de ce procédé, est relativement lourde et onéreuse.

Une solution alternative, visant l'élimination de cette couche limite, a été proposée par WO 2008/136029. Ce document décrit une installation de traitement plasma à la pression atmosphérique d'un matériau en bande continue, comprenant une chambre fermée destinée à la réception d'un poste de traitement par plasma. Cette chambre est munie d'un système d'étanchéité associé à des lèvres appuyant, en service, sur le substrat défilant à traiter. Cet agencement présente également des limites, notamment en ce qu'il ne permet pas à une vitesse élevée de traitement. Par ailleurs, il ne se prête pas au traitement de substrats tels que des films, dans la mesure où il est susceptible de créer des rayures intempestives à la surface de ces derniers.

On citera en outre JP 2016/062812 qui décrit une installation faisant appel à au moins un poste de traitement, dans lequel est ménagée une chambre d'admission en gaz plasmagène. Selon l'enseignement de ce document, la distance séparant le substrat défilant et la face en regard du poste de traitement, est réduite afin de minimiser l'entrée d'air. Cependant, l'efficacité d'une telle installation se révèle insuffisante, notamment dans le cas où le substrat est à traiter à grande vitesse.

Il est par ailleurs connu d'utiliser, en entrée de la zone de traitement, un rouleau presseur qui a pour fonction de plaquer le substrat sur le rouleau support pour éviter la formation de poches d'air sous le substrat. Un tel dispositif, qui est très largement utilisé et décrit dans l'art antérieur, se révèle cependant insuffisant en vue de résoudre le problème technique lié à l'inertage de la zone de traitement.

Enfin FR 3 035 122 décrit une installation de traitement comprenant une enceinte, un support pour le substrat, une contre électrode, au moins une tête pourvue d'au moins une électrode adaptée pour créer une décharge électrique, ainsi que de moyens de diffusion d'un gaz inerte et de moyens d'injection d'un mélange gazeux actif vers le support. Selon l'enseignement de ce document, les moyens d'injection sont placés entre les moyens de diffusion et le support, alors que la tête et le support définissent au moins une sortie pour le gaz inerte et/ou le mélange gazeux actif.

Compte tenu de ce qui précède, un objectif de la présente invention est de remédier, au moins partiellement, aux inconvénients de l'art antérieur évoqués ci-dessus.

Un autre objectif de l'invention est de proposer un dimensionnement judicieux d'une installation de traitement de surface sous atmosphère contrôlée, de manière à augmenter l'efficacité de l'inertage de la zone de traitement appartenant à cette installation.

Un autre objectif de l'invention est de proposer une telle installation, permettant de maximiser l'effet du traitement pour pouvoir traiter des substrats souples à grande vitesse.

Un autre objectif de l'invention est de proposer une telle installation qui, tout en assurant un traitement de surface fiable d'un substrat, notamment de type "roll to roll", à une pression proche de la pression atmosphérique, permet de réduire significativement la quantité de gaz consommée par rapport à l'art antérieur.

Un autre objectif de l'invention est de proposer une telle installation, qui est commode à piloter et qui peut être mise en œuvre de façon relativement simple.

### Objets de l'invention

Selon l'invention, les objectifs ci-dessus sont atteints tout d'abord grâce à une installation selon la revendication 1 annexée.

L'installation conforme à l'invention utilise un gaz dit de traitement, dont la nature varie en fonction de différents types de traitements, englobés dans le cadre de l'invention. Ainsi, dans un premier mode de réalisation, le traitement de l'invention est un traitement plasma. Dans ce cas, le gaz de traitement comprend notamment un gaz plasmagène, associé éventuellement à des dopants. Dans un mode de réalisation alternatif, le traitement de l'invention est la réticulation de résines photosensibles. Dans ce cas, le gaz de traitement est un gaz d'inertage. La nature de ce gaz de traitement peut être encore différente, dans le cas d'un autre type de traitement conforme à la présente invention.

De façon générale, on appellera gaz d'inertage tout gaz permettant de chasser l'oxygène hors du volume du capot de confinement, indépendamment de toute autre fonction. Typiquement, cette définition comprend les gaz tels que l'azote et les gaz nobles, entre autres l'hélium ou l'argon. Un gaz plasmagène, utilisé dans un procédé de traitement plasma, permet la création du plasma. Il correspond au gaz d'inertage dans d'autres procédés, car il a également pour fonction de chasser l'oxygène hors du volume du capot de confinement.

Il est du mérite de la Demanderesse d'avoir constaté que les inconvénients de l'art antérieur sont dus, en majeure partie, au fait que l'air présent en aval du rouleau presseur vient regarnir la couche limite avant d'entrer dans la zone de traitement proprement dite. La Demanderesse a en outre identifié que ce phénomène est notamment lié à un positionnement mutuel peu approprié des différents éléments constitutifs de l'installation, à savoir le tambour, le rouleau presseur et l'ensemble de traitement. En particulier la Demanderesse s'est rendu compte que, si ce rouleau presseur permet d'éliminer la couche d'air entre le substrat et le tambour support, ce rouleau presseur n'est pas suffisant en vue de l'élimination de la couche d'air présente au-dessus de ce substrat.

Dans ces conditions, l'invention prévoit tout d'abord de loger l'ensemble de traitement, au sein d'un capot de confinement. Les moyens de recyclage, conformes à l'invention, permettent de recycler une partie du gaz de traitement injecté par les moyens d'injection. Le trajet de recyclage s'effectue en dehors de ces moyens d'injection, mais à l'intérieur du volume formé par le capot et le substrat en regard.

Tout ou partie du gaz de traitement ainsi recyclé est alors admis dans un volume de recirculation, délimité selon l'invention par le bord d'extrémité de la paroi frontale amont du capot, par le rouleau presseur, par le support et par l'extrémité amont de l'ensemble de traitement. Le fait de positionner ce bord d'extrémité au plus près du rouleau presseur facilite le refoulement de l'air ambiant, par l'intermédiaire du gaz de traitement présent dans ce volume de recirculation. En d'autres termes, on empêche toute entrée significative d'air ambiant dans ce volume de recirculation et, par conséquent, en direction de la zone de traitement.

L'invention s'appuie donc notamment sur un dimensionnement judicieux de l'installation de traitement qui en fait l'objet. La Demanderesse a constaté que le fait de maîtriser certains paramètres dimensionnels de cette installation permet d'éliminer, de façon mécanique, la couche limite d'air à la surface du substrat avant qu'il n'entre dans la zone de traitement.

Cette structure permet ainsi d'obtenir un substrat sans couche limite d'air, tout en conférant des vitesses de traitement élevées, typiquement de l'ordre de 100 à 800 m/min. On notera également que l'invention ne génère pas d'augmentation significative de la consommation de gaz de traitement. De plus, l'invention permet de s'affranchir de l'utilisation d'unités d'entrée et de sortie associées à des couteaux d'azote, telles que connues de FR-A-2 816 726. La structure globale de l'installation selon l'invention s'en trouve, par conséquent, nettement simplifiée.

Enfin on notera que la structure de l'installation conforme à l'invention diffère substantiellement de celle décrite dans FR 3 035 122, présenté ci-dessus. En effet ce document antérieur ne décrit pas un capot de confinement, qui est distinct de l'ensemble de traitement. Par ailleurs, dans ce document, le rouleau presseur est éloigné de l'ensemble de traitement de sorte qu'il n'est pas de nature à délimiter un volume de recyclage avec cet ensemble de traitement.

Des caractéristiques additionnelles de l'invention font l'objet des revendications 2 à 13 annexées.

Ces caractéristiques additionnelles peuvent être mises en œuvre individuellement ou en combinaisons quelconques, techniquement compatibles.

Les objectifs ci-dessus sont également atteints grâce à un procédé de dimensionnement selon la revendication 14 annexée.

### Description des figures

L'invention va être décrite ci-après, en référence aux dessins annexés, donnés uniquement à titre d'exemples non limitatifs, dans lesquels:
La figure 1 est une vue en perspective, illustrant une installation de traitement de surface conforme à un premier mode de réalisation de l'invention.
La figure 2 est une vue de face illustrant de façon partielle, à bien plus grande échelle, le positionnement respectif du tambour, du rouleau presseur et des blocs de traitement, appartenant à l'installation conforme à l'invention.
La figure 3 est une vue de face, analogue à la figure 2, illustrant la circulation des gaz lors de la mise en œuvre de l'installation conforme à l'invention.
La figure 4 est une vue de face, analogue aux figures 2 et 3, illustrant une installation de traitement de surface conforme à un deuxième mode de réalisation de l'invention.
La figure 5 est une vue en perspective, illustrant une tête de traitement de surface appartenant à l'installation de la figure 4.
La figure 6 est une vue de face, analogue aux figures 2 et 3, illustrant une installation de traitement de surface conforme à un troisième mode de réalisation de l'invention.
La figure 7 est une courbe, illustrant les variations du taux d'oxygène dans l'enceinte de confinement, appartenant à l'installation conforme à l'invention, en fonction de la vitesse de défilement du substrat.
La figure 8 est une vue de face, analogue à la figure 2, illustrant une variante de l'installation de traitement conforme au premier mode de réalisation de l'invention.

Les références numériques suivantes sont utilisées dans la présente description:

| 1 Tambour | R1 Rotation de 1 |
|---|---|
| D1 Diamètre de 1 | L1 Longueur de 1 |
| 2 Nip (rouleau presseur) | R2 Rotation de 2 |
| D2 Diamètre de 2 | L2 Lonqueur de 2 |
| SUB Substrat | F1 F2 Déplacement de SUB |
| 3A - 3D Blocs | 31 36 Parois supérieure inférieure de 3 |
| 32 33 Parois amont aval de 3 | 34 35 Parois latérales de 3 |
| 37 Orifices d'injection de 3 | 37' Alimentation de 37 |
| 38 Logement de 8 | 8 Electrode |
| 39 Extrémité amont de 3 | 39' Bord supérieur amont de 3 |
| 4 Capot de confinement | 41 Paroi supérieure de 4 |
| 42 43 Parois amont aval de 4 | 44 45 Parois latérales de 4 |
| d1 Distance entre 39 et 1 | d2 Distance entre 42' et 2 |
| d3 Distance entre 42 et 39' | d4 Distance entre 33 et 32B |
| d5 Distance entre 32 et 2 | |
| 5 Déflecteur | 6 Chemin de renvoi |
| 101 Tambour | 102 Nip (rouleau presseur) |
| 103A 103B Têtes | 131 Couvercle |
| 132 Paroi avant de 103 | 133 Paroi arrière de 103 |
| 134 Paroi latérale de 103 | 135 Paroi latérale de 103 |
| 104 Capot de confinement | V103 Volume intérieur de 103 |
| 132' 133' Bords libres | E S Entrée Sortie |
| 142 Diffuseurs | 140 150 Parties de la tête |
| 160 Filtre | 137 - 137" Tubes |
| 108 - 108" Electrodes | 106 Chemin de renvoi |
| 201 Tambour | 202 Nip (rouleau presseur) |
| 204 Capot de confinement | 208 - 208' Electrodes |
| 206 Chemin de renvoi | 237 - 237' Tubes |

### Description détaillée

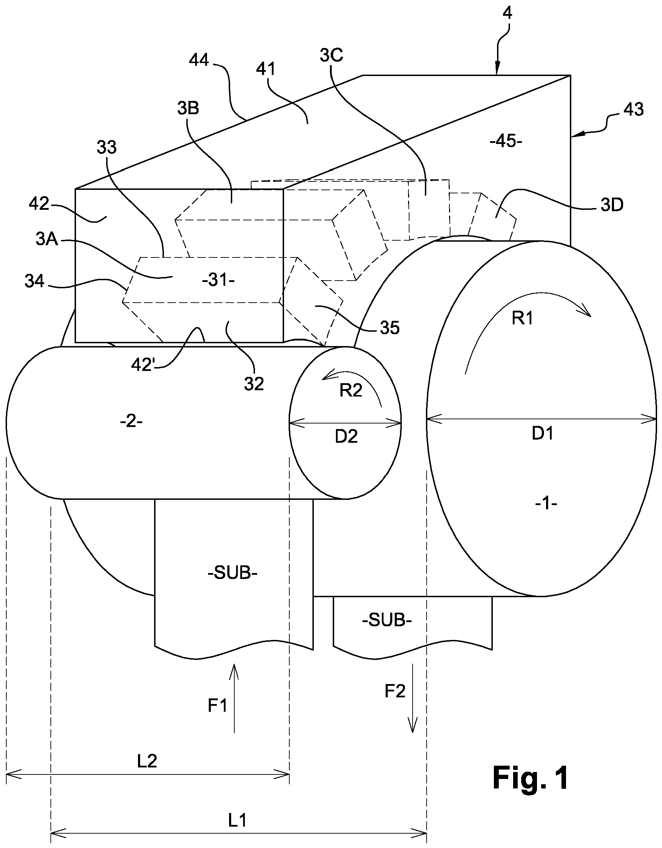

Les figures 1 à 3 illustrent une installation de traitement de surface, conforme à une première variante de réalisation de l'invention. Comme le montrent ces figures cette installation comprend essentiellement un tambour 1, formant support pour un substrat SUB, un rouleau presseur 2, un ensemble de traitement formé par plusieurs blocs de traitement 3A à 3F, ainsi qu'un capot de confinement 4 recouvrant ces blocs.

Le tambour 1 de type connu en soi est mis en rotation, en service, selon la direction matérialisée par la flèche R1. On note D1 son diamètre et L1 sa dimension longitudinale. Ce tambour forme un support pour le substrat SUB, destiné à circuler selon les flèches F1 et F2, de sorte à être traité conformément à l'invention. Dans le présent mode de réalisation, ce tambour assure une fonction supplémentaire de contre électrode, laquelle coopère avec des électrodes qui seront décrites dans ce qui suit. A cette fin, ce tambour est avantageusement recouvert d'une couche isolante, de manière connue en soi. Cependant, cette contre électrode peut être formée par un autre composant de l'installation. A titre d'exemple, le substrat est fait de polypropylène, alors que son épaisseur est comprise entre 20 et 100 micromètres.

Dans sa partie amont, en référence au déplacement du substrat, le tambour 1 est associé au rouleau presseur 2 (appelé par l'homme du métier aussi "Nip"), également de type connu en soi. Comme cela sera décrit plus en détail dans ce qui suit, le rouleau secondaire 2 est mis en rotation, en service, selon la direction matérialisée par la flèche R2. Cela permet de presser le substrat contre le tambour 1, de manière à éviter la formation d'une couche d'air entre ce substrat et ce tambour. Ceci permet d'éviter tout défaut local de traitement sur le substrat. On note D2 son diamètre, lequel est bien inférieur à celui D1 du tambour 1, ainsi que L2 sa dimension longitudinale, laquelle est par exemple voisine de celle L1 du tambour 1.

L'ensemble de traitement comprend plusieurs blocs massifs 3A à 3D, lesquels sont avantageusement identiques. Chaque bloc est avantageusement réalisé dans un matériau isolant, de tout type approprié. Le bloc est réalisé par tout procédé mécanique approprié, notamment par usinage. On va maintenant décrire la structure de l'un 3A de ces blocs, sachant que celle des autres blocs est similaire.

Le bloc 3A possède une paroi supérieure 31 et des parois périphériques, formées par des parois parallèles respectivement avant ou amont 32, et arrière ou aval 33, ainsi que des parois latérales parallèles 34 et 35. A titre d'exemple, sa longueur L3, à savoir la distance entre les parois 34 et 35, est comprise entre 1 000 mm et 2 000 mm. A titre d'exemple, sa largeur l3, à savoir la distance entre les parois 32 et 33, est comprise entre 50 mm et 200 mm. Chaque bloc est fixé par tout moyen approprié, de préférence de façon amovible, sur les parois latérales du capot 4, qui va être décrit dans ce qui suit.

Ce bloc 3A possède en outre une paroi inférieure 36, tournée vers le tambour 1. Dans ce premier mode de réalisation, cette paroi 36 est sensiblement pleine. Elle est creusée d'au moins un orifice 37, permettant l'injection de gaz dans l'espace formé entre cette paroi 36 et le tambour 1. Cet orifice d'injection 37 peut prendre la forme d'une série de trous, répartis linéairement ou en quinconces entre les parois 34 et 35, en regard du tambour 1. De façon préférée, ces orifices sont formés par une ou plusieurs fentes longitudinales, s'étendant entre les parois 34 et 35.

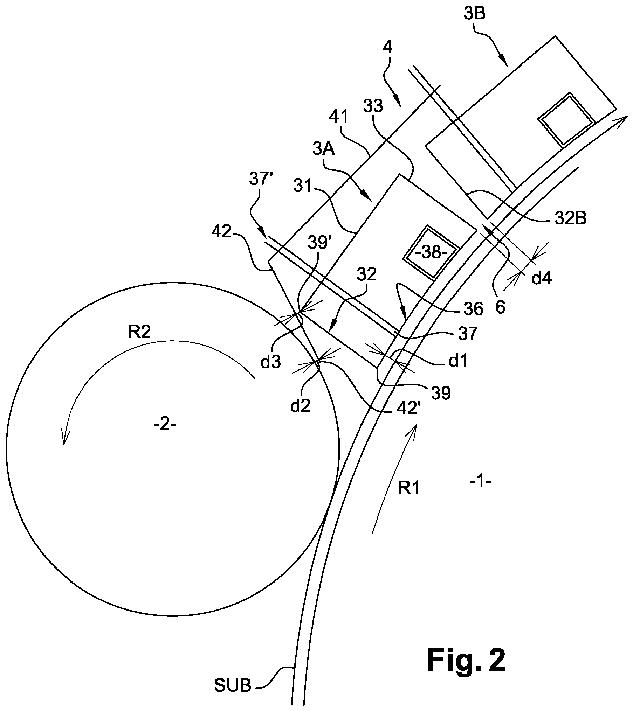

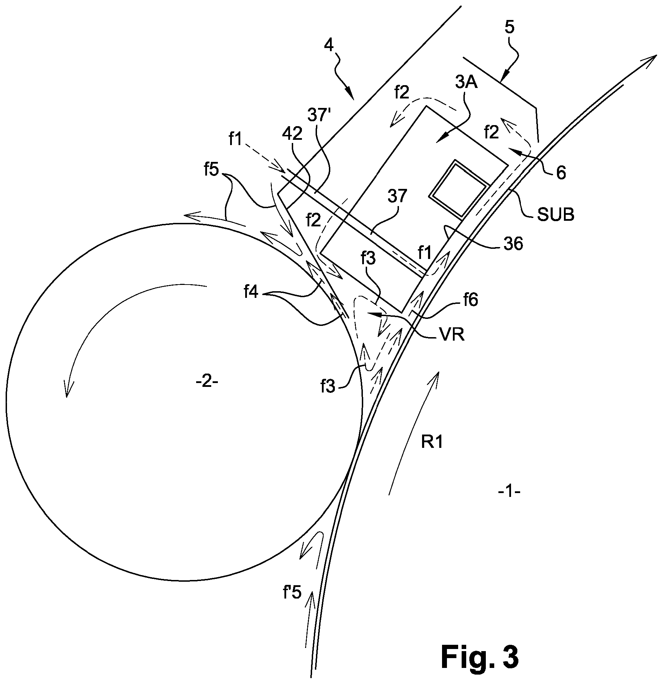

Dans l'exemple illustré, on retrouve une unique fente 37 mais on peut prévoir plusieurs fentes parallèles, disposées les unes derrière les autres en référence au sens de défilement du substrat. Durant la mise en oeuvre de l'installation, comme cela sera explicité dans ce qui suit, on peut injecter à la fois un gaz plasmagène, mais aussi un gaz auxiliaire. Au niveau de leur débouché sur la paroi supérieure, ces orifices 37 sont reliés à une source non représentée de tout type approprié pour l'alimentation en gaz plasmagène et, le cas échéant, en gaz auxiliaire. Ces alimentations sont matérialisées, de manière schématique, par la référence 37' sur les figures 2 et 3.

L'électrode 8, de type connu en soi, est placée dans le bloc 3A, en étant par exemple reçue dans un logement 38 ménagé dans ce bloc. Cette électrode est de préférence réalisée en matériau céramique, ce qui permet de traiter un substrat électriquement conducteur. A titre d'alternative, les électrodes peuvent être réalises en tout autre matériau approprié, comme en matériau métallique. Cette électrode 8 est connectée à une source de puissance, non représentée.

On note 39 l'extrémité dite amont de ce bloc 3A, correspondant à l'intersection entre les parois respectivement amont 32 et inférieure 36. Cette extrémité 39 forme également l'extrémité amont de l'ensemble de traitement. On note par ailleurs 39' le bord supérieur amont de ce bloc 3A, correspondant à l'intersection entre les parois respectivement amont 32 et supérieure 31.

L'installation de l'invention comprend en outre un capot dit de confinement 4, dont le volume intérieur définit une enceinte dite de confinement, dans laquelle sont reçus les blocs 3. En coupe transversale ce capot 4 présente une forme dite de U à ailes évasées. A titre de variante il peut présenter des formes différentes, telles que par exemple un U à ailes droites ou encore une forme arrondie. Ce capot 4 comprend une paroi supérieure ou âme 41, deux parois frontales ou ailes 42 et 43, ainsi que deux parois latérales 44 et 45 visibles sur la figure 1. En référence au sens de rotation du tambour, l'aile 42 est dénommée aile amont, alors que l'aile 43 est dénommée aile aval.

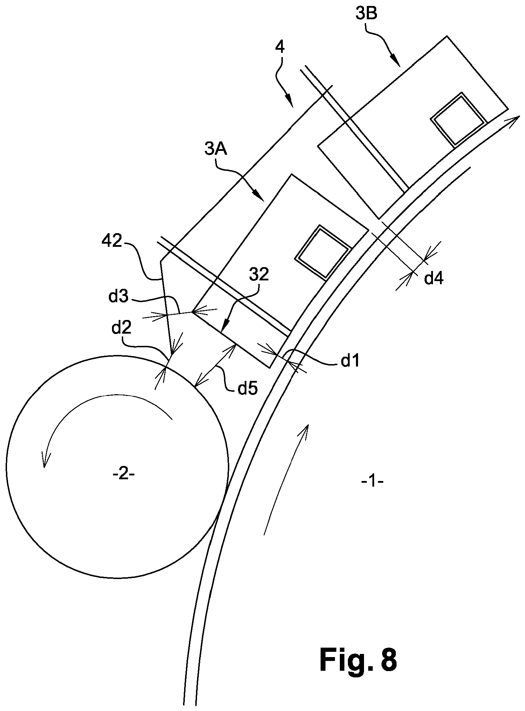

Selon l'invention, on choisit avantageusement certaines dimensions caractéristiques dans une plage de valeurs parfaitement définie :
- la plus petite distance (d2) entre le bord d'extrémité 42' de la paroi amont 42 du capot 4 et le rouleau presseur 2 est choisie inférieure à 15 millimètres, de préférence inférieure à 5 millimètres ;
- la plus petite distance (d3) entre la paroi amont 42 du capot 4 et l'ensemble de traitement est choisie inférieure à 20 millimètres, de préférence inférieure à 2 millimètres. Cette distance sépare la paroi précitée 42 par rapport au bord supérieur 39' du bloc 3A ;
- la plus petite distance (d1) entre l'extrémité amont 39 de l'ensemble de traitement et le support est choisie inférieure à 5 millimètres, de préférence inférieure à 2 millimètres.
- la plus petite distance (d4) entre un premier bloc de traitement, tel celui 3A, et le bloc de traitement suivant, tel celui 3B, est choisie entre d1 et 10 mm, de préférence entre d1 et 2*d1. Dans le cas d'un bloc de traitement unique, cette distance (d4) sépare ce bloc de traitement et la paroi aval en regard du capot de confinement.
   - la plus petite distance (d5) entre le rouleau presseur 2 et l'ensemble de traitement est inférieure à 10 millimètres, de préférence inférieure à 5 millimètres. Cette distance est montrée sur la figure 8, laquelle illustre une géométrie du capot 42 légèrement différente de celle représentée en figure 2. Cette distance (d5) sépare le rouleau 2 et la paroi amont 32 du bloc 3A.

Différentes possibilités de mise en œuvre de l'installation, conforme à l'invention, vont maintenant être explicitées dans ce qui suit.

De manière générale, on admet un gaz de traitement dans la zone de traitement de l'installation conforme à l'invention. Dans le présent mode de réalisation, ce gaz est constitué d'un gaz plasmagène tel que l'azote, l'argon, ou encore l'hélium, auquel on peut adjoindre d'autres gaz ou composés vaporisés en proportions très inférieures, appelés dopants.

En général, dans une phase préalable, on admet tout d'abord du gaz plasmagène, tel de l'azote, dans la zone de traitement. Cette admission est réalisée par des premiers orifices, prévus en amont. On ne met pas en mouvement le substrat, avant que la concentration en oxygène ne tombe au-dessous d'un seuil donné, par exemple égal à 20 ppm (parties par million). Quand la valeur de cette concentration est appropriée, on déplace alors le substrat grâce au support et on génère une décharge par les électrodes 8. Par ailleurs des dopants sont optionnellement injectés par des seconds orifices, éventuellement prévus en aval des orifices d'admission de gaz plasmagène.

En service, on constate que l'installation de l'invention permet la création d'un volume VR, visible sur la figure 3, dénommé ici volume de recirculation. Sur cette figure, le trajet de l'air est matérialisé par des traits pleins, alors que celui du gaz plasmagène est matérialisé par des traits pointillés. Ce volume est délimité respectivement par trois passages de section réduite :
- le premier (de section d1) est ménagé entre la paroi d'extrémité amont 39 du premier bloc 3A et le substrat SUB défilant sur le rouleau support 1,
- le deuxième (de section d2) est ménagé entre le rouleau presseur 2 et le bord 42' du capot de confinement 4, et
- le troisième (de section d3) est ménagé entre le capot de confinement 4 et le bloc de traitement 3A.

Plus précisément le gaz plasmagène injecté hors des orifices 37 s'écoule tout d'abord vers l'aval selon les flèches f1, entre la paroi inférieure 36 et le substrat SUB. Conformément à l'invention, ce gaz est ensuite recyclé pour partie vers l'amont du bloc 3A, selon les flèches f2. Dans l'exemple illustré, ce phénomène de recyclage, ou de renvoi, est assuré par le positionnement du second bloc 3B. En effet, l'injection de gaz plasmagène, effectuée au niveau des orifices de ce second bloc 3B, permet d'éviter l'écoulement vers l'aval d'une partie du gaz injecté en 3A et, par conséquent, de recycler ce gaz. A titre de variante, par exemple dans le cas où il est prévu un unique bloc, ce recyclage peut être assuré en utilisant un déflecteur 5 de type mécanique, formant paroi de renvoi, lequel est illustré en traits mixtes sur la figure 3. De façon avantageuse, l'extrémité inférieure de ce déflecteur est placé à une distance (d4), telle que définie ci-dessus, de l'extrémité aval en regard du bloc 3A.

Les parois en regard des deux blocs les plus en amont 3A et 3B définissent un chemin de recyclage 6 pour le gaz plasmagène, dans lequel celui-ci s'écoule radialement vers l'extérieur du support 1. La section de ce chemin de recyclage est égale à la distance (d4), telle que définie ci-dessus. En pratique, on met en œuvre l'installation, de sorte qu'une fraction appropriée du gaz plasmagène est recyclée vers l'amont, afin de bloquer l'air ambiant comme expliqué ci-dessous. Par ailleurs, une autre fraction de ce gaz s'écoule librement vers l'aval de manière à assurer le traitement. Enfin, l'encombrement global du bloc de traitement reste raisonnable.

Le gaz plasmagène, ainsi renvoyé vers l'amont, est admis dans le volume VR précité à travers l'espace d3. Cet espace est dimensionné de telle manière que la forme du volume au-dessus des blocs de traitement n'influence pas le flux de ce gaz. Dans ce but d3 est inférieure à 20 mm et, de préférence, inférieure à 2 mm. Ce gaz est alors soumis à une recirculation au sein de ce volume VR, selon les flèches f3, Une partie de ce gaz vient garnir la couche limite sur le rouleau presseur puis est entrainée à l'extérieur, selon les flèches f4. Cela empêche la pénétration de l'air, qui est renvoyé selon les flèches f5, d'autant plus que la dimension d2 est réduite. Une autre partie du gaz plasmagène, qui vient garnir la couche limite sur le substrat en aval du rouleau presseur, est entrainée sous le bloc selon les flèches f6. On a aussi illustré, sur cette figure 3, l'action supplémentaire de type connue en soi du rouleau presseur, qui enlève l'air de la couche limite selon la flèche f'5.

Selon l'invention, on positionne le bord 42' au plus près du rouleau presseur 2. En d'autres termes, la dimension d2 est aussi faible que possible. L'homme du métier ajustera le capot de confinement 4, de sorte que le bord précité 42' soit placé à proximité immédiate du rouleau 42, tout en n'entravant pas sa libre rotation. De façon avantageuse, cette distance d2 est choisie inférieure à 15 mm, de préférence à 5 mm, comme mentionné ci-dessus.

De préférence, la distance entre le rouleau presseur et le premier dispositif d'injection est minimisée dans la mesure du possible. Cela permet de réduire la taille globale du volume de recirculation et, par conséquent, le temps nécessaire pour l'inertage de ce volume VR. Aucun dispositif d'aspiration des gaz n'est placé dans le volume intérieur du capot de confinement. En revanche, on prévoit avantageusement un tel dispositif d'aspiration, dans l'enceinte de plus grande dimension recevant l'ensemble des composants de l'installation.

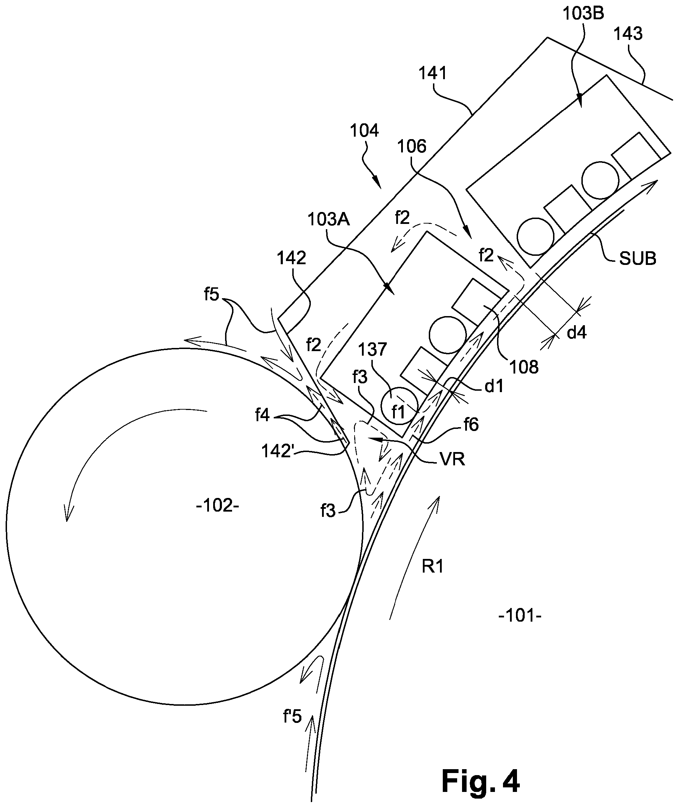

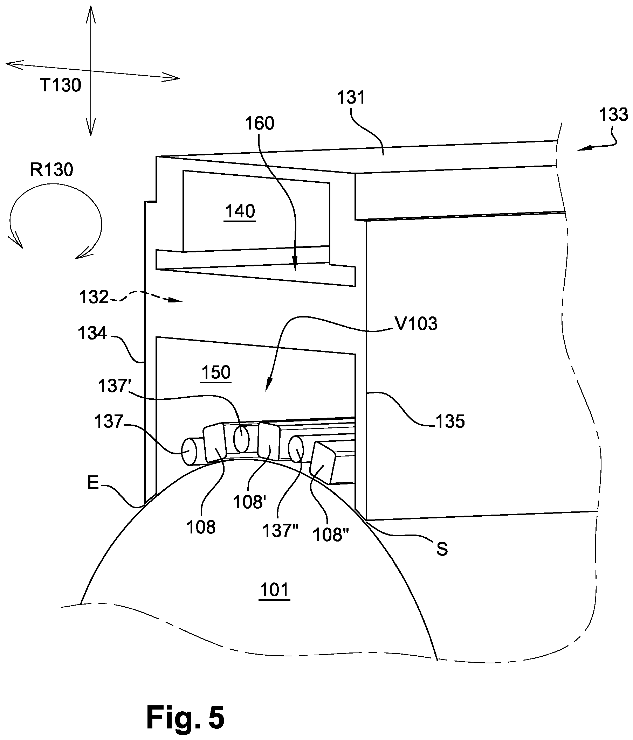

Les figures 4 et 5 illustrent une installation de traitement de surface, conforme à une deuxième variante de réalisation de l'invention. Sur ces figures les éléments mécaniques, analogues à ceux des figures 1 à 3, y sont affectés des mêmes numéros de référence augmentés de 100. Ce deuxième mode de réalisation diffère du premier, essentiellement en ce que l'ensemble de traitement comprend au moins une tête ouverte en direction du tambour 1. Dans l'exemple illustré, plusieurs têtes 103A et 103B sont prévues, lesquelles sont avantageusement identiques. Ainsi, on va décrire uniquement la structure de la tête 103A, en référence notamment à la perspective de la figure 5.

Cette tête 103, qui est prévue au-dessus du tambour 1, est équipée de tubes et d'électrodes comme cela sera expliqué dans ce qui suit. Cette tête s'étend selon un arc du cercle défini par le tambour 1, de manière approximativement centrale. Elle comprend un couvercle 131 et des parois périphériques, formées par des parois parallèles avant et arrière 132 et 133, ainsi que par des parois latérales 134 et 135. A titre d'exemple, elle est réalisée en PET (polyéthylène téréphtalate). La tête est fixée sur le capot 4, par tout moyen approprié, notamment de façon amovible.

La tête 103 diffère principalement du bloc du premier mode de réalisation, en ce qu'elle ne possède pas une paroi de fond sensiblement pleine, comme celle dont est pourvu ce bloc. Cette tête 103 définit donc un volume intérieur V103 qui est ouvert en direction du tambour 1, comme cela est notamment visible en figure 5, sur laquelle le capot de confinement n'est pas représenté dans un but de clarté. Le tambour définit, avec chaque bord libre 132' et 133' de la tête, deux espaces formant respectivement une entrée E et une sortie S.

L'entrée E correspond au côté amont, par lequel est admis le substrat, alors que la sortie S correspond au côté aval. Cette entrée E forme l'extrémité amont de l'ensemble de traitement, au sens de l'invention. La hauteur de cette entrée E définit aussi la distance d1, telle que présentée en référence au premier mode de réalisation. La valeur de la hauteur de chaque espace E et S peut être modifiée, en déplaçant la tête 103 par rapport au tambour 1 en translation (flèche T130) et/ou rotation (flèche R130).

Dans un mode de réalisation optionnel, la tête est divisée en deux parties par un filtre 160, dénommées ci-après parties supérieure 140 et inférieure 150. Dans sa partie supérieure 140, la tête est munie de diffuseurs 142, de tout type approprié, reliés à une source de gaz plasmagène. Ce filtre, qui est connu en soi, possède entre autres la fonction d'améliorer l'homogénéité du gaz envoyé vers la partie inférieure 150 de la tête.

La partie inférieure de la tête reçoit tout d'abord des tubes d'injection 137, 137' et 137", prévus au nombre de trois. On notera que, sur la figure 4, seuls deux tubes sont illustrés de façon schématique. A titre de variante, on peut prévoir un nombre différent d'organes d'injection et/ou on peut prévoir que ces organes d'injection sont structurellement différents d'un tube, à savoir qu'ils sont formés par exemple par un barreau perforé. La partie inférieure de la tête reçoit en outre trois électrodes 108, 108' et 108", qui sont agencées alternativement par rapport aux tubes ci-dessus, selon le sens de rotation du tambour.

Selon d'autres variantes non représentées, les agencements mutuels de tubes et d'électrodes sont différents. A titre d'exemple, deux électrodes peuvent être placées côte à côte, ou bien un premier tube peut être disposé entre une électrode amont et la paroi latérale en regard. Deux tubes peuvent aussi être placés côte à côte, en étant disposés entre deux électrodes ou entre une paroi latérale et une électrode. A titre d'exemple, les tubes sont réalisés en métal, ou en matière plastique, comme en un matériau polymère, en particulier en PET.

Chaque tube 137, qui est de forme allongée, présente par exemple une section transversale circulaire. Son diamètre externe est par exemple compris entre 10 et 20 millimètres. Chaque tube 137 est percé par exemple de deux rangées parallèles d'orifices d'injection, notamment mutuellement décalées, réalisées par tout procédé approprié. Chaque électrode 108 est par exemple similaire à celles 8 du premier mode de réalisation. Cette électrode peut aussi être remplacée par une autre électrode, de type différent.

En service, on peut prévoir d'injecter uniquement du gaz plasmagène, tel de l'azote, en direction du substrat. Dans ce cas, ce gaz est admis par les tubes 137 et/ou par les diffuseurs 142. A titre de variante, on peut prévoir d'injecter du gaz plasmagène ainsi que du gaz auxiliaire, en direction du substrat. Dans ce cas, le gaz plasmagène est typiquement admis par les diffuseurs 142, alors que le gaz auxiliaire est typiquement admis par les tubes 137.

De façon analogue à ce qui a été décrit en référence au premier mode de réalisation, l'installation conforme à ce deuxième mode de réalisation permet la création d'un volume de recirculation VR, visible sur la figure 4. Sur cette figure, le trajet de l'air est matérialisé par des traits pleins, alors que celui du gaz plasmagène est matérialisé par des traits pointillés. Ce volume est délimité respectivement par les trois mêmes passages de section réduite :
- le premier (de section d1) est ménagé entre l'entrée E de la première tête 103A et le substrat SUB défilant sur le rouleau support 101,
- le deuxième (de section d2) est ménagé entre le rouleau presseur 102 et le bord 142' du capot de confinement 104, et
- le troisième (de section d3) est ménagé entre l'aile 142 du capot de confinement 104 et la tête de traitement 103A.

Plus précisément le gaz plasmagène injecté hors du volume V103 de la tête 103A s'écoule tout d'abord vers l'aval selon les flèches f1, puis est recyclé vers l'amont de cette tête 103A, selon les flèches f2. Dans l'exemple illustré, ce phénomène de recyclage est amélioré par l'injection de gaz plasmagène, effectuée au niveau de la seconde tête 103B. A titre de variante, par exemple dans le cas où il est prévu une unique tête, ce renvoi peut être amélioré en utilisant un déflecteur de type mécanique, analogue à celui 5 de la figure 3.

Les parois en regard des deux têtes 103A et 103B définissent un chemin de recyclage 106 pour le gaz plasmagène, dans lequel celui-ci s'écoule radialement vers l'extérieur du support 101. On note d4 la distance séparant ces deux têtes, laquelle définit la section de ce chemin de recyclage. Cette valeur de d4 est analogue à celle décrite ci-dessus, tout comme les valeurs de d1 à d3.

Le gaz plasmagène, ainsi renvoyé vers l'amont, est admis dans le volume VR précité. Ce gaz est alors soumis à une recirculation au sein de ce volume, selon les flèches f3. Une partie de ce gaz vient garnir la couche limite sur le rouleau presseur puis est entrainée à l'extérieur, selon les flèches f4. Cela empêche la pénétration de l'air, qui est renvoyé selon les flèches f5, du fait de la présence de l'espace de dimension réduite d2. Une autre partie du gaz plasmagène, qui vient garnir la couche limite sur le substrat en aval du rouleau presseur, est entrainée sous le bloc selon les flèches f6.

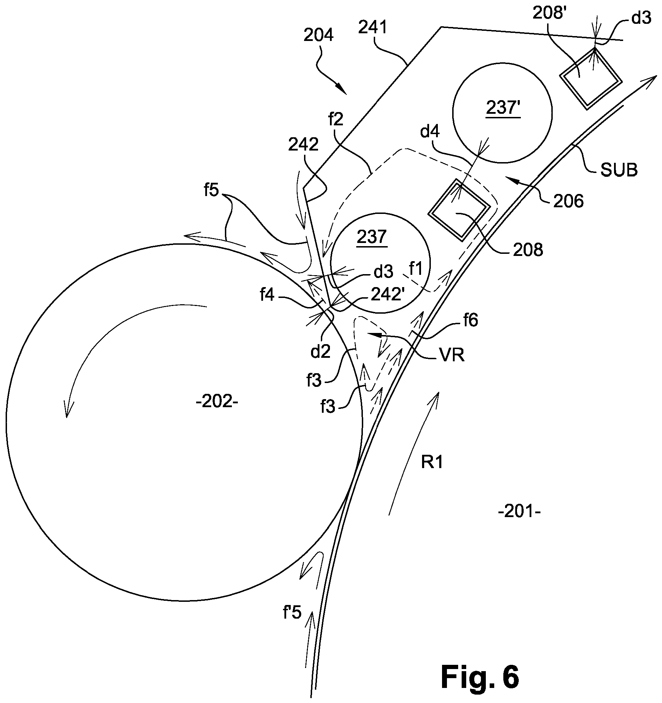

La figure 6 illustre une installation de traitement de surface, conforme à une troisième variante de réalisation de l'invention. Sur cette figure les éléments mécaniques, analogues à ceux des figures 1 à 3, y sont affectés des mêmes numéros de référence augmentés de 200.

Ce troisième mode de réalisation diffère du deuxième mode de réalisation, essentiellement en ce que l'ensemble de traitement comprend une succession de tubes d'injection et d'électrodes, qui sont reçus directement dans le capot de confinement 204. En d'autres termes, ce troisième mode de réalisation ne fait pas appel à un organe mécanique intermédiaire, telle que la tête 103, interposée entre le capot de confinement et les tubes et électrodes.

Les tubes d'injection et les électrodes sont donc fixés directement sur les parois latérales du capot, d'une manière similaire à leur fixation sur la tête dans le deuxième mode de réalisation. Par ailleurs, ces tubes et ces électrodes présentent des dimensions analogues, à celles des tubes et électrodes du deuxième mode de réalisation. Dans l'exemple illustré, on retrouve deux tubes d'injection 237 et 237', ainsi que deux électrodes 208 et 208', ces tubes et électrodes étant prévus de façon alternée selon le défilement du substrat. A titre de variante on peut prévoir un nombre et/ou un agencement différent(s) de ces tubes et électrodes.

En service, on peut prévoir d'injecter uniquement du gaz plasmagène, tel de l'azote, en direction du substrat. Dans ce cas, ce gaz est admis par les tubes 237. A titre de variante, on peut prévoir d'injecter du gaz plasmagène ainsi que du gaz auxiliaire, en direction du substrat.

De façon analogue à ce qui a été décrit en référence au premier mode de réalisation, l'installation conforme à ce troisième mode de réalisation permet la création d'un volume de recirculation VR, visible sur la figure 6. Sur cette figure, le trajet de l'air est matérialisé par des traits pleins, alors que celui du gaz plasmagène est matérialisé par des traits pointillés. Ce volume est délimité respectivement par les trois mêmes passages de section réduite :
- le premier (de section d1) est ménagé entre la face inférieure du tube amont 237 et le substrat SUB défilant sur le rouleau support 101,
- le deuxième (de section d2) est ménagé entre le rouleau presseur 102 et le bord 242' du capot de confinement 204, et
- le troisième (de section d3) est ménagé entre le capot de confinement 204 et le tube amont 237.

Plus précisément le gaz plasmagène injecté hors du tube amont 237 s'écoule tout d'abord vers l'aval selon les flèches f1, puis est renvoyé vers l'amont de ce tube 237, selon les flèches f2. Dans l'exemple illustré, ce phénomène de renvoi est amélioré par l'injection de gaz plasmagène, effectuée au niveau du tube aval 237'. A titre de variante, par exemple dans le cas où il est prévu une unique tête, ce renvoi peut être amélioré en utilisant un déflecteur de type mécanique, analogue à celui 5 de la figure 3.

Les parois en regard de l'électrode amont 208 et du tube aval 237' définissent un chemin de recyclage 206 pour le gaz plasmagène, dans lequel celui-ci s'écoule radialement vers l'extérieur du support 201. On note d4 la distance séparant cette électrode amont 208 et ce tube aval 237', laquelle définit la section de ce chemin de recyclage. On note d4 la distance séparant ces deux têtes, laquelle définit la section de ce chemin de recyclage. Cette valeur de d4 est analogue à celle décrite ci-dessus, tout comme les valeurs de d1 à d3.

Le gaz plasmagène, ainsi renvoyé vers l'amont, est admis dans le volume VR précité. Ce gaz est alors soumis à une recirculation au sein de ce volume, selon les flèches f3. Une partie de ce gaz vient garnir la couche limite sur le rouleau presseur puis est entraînée à l'extérieur, selon les flèches f4. Cela empêche la pénétration de l'air, qui est renvoyé selon les flèches f5, du fait de la présence de l'espace de dimension réduite d2. Une autre partie du gaz plasmagène, qui vient garnir la couche limite sur le substrat en aval du rouleau presseur, est entrainée sous le bloc selon les flèches f6.

L'invention n'est pas limitée aux exemples décrits et représentés. Ainsi, comme mentionné au début de la description des figures, le traitement mis en œuvre selon l'invention peut être d'un type différent d'un traitement plasma. Par ailleurs, le support du substrat peut être différent d'un tambour rotatif. En variante, il peut notamment s'agir d'un support plan immobile, tel une plaque, sur lequel défile le substrat en mouvement.

### Exemples

L'invention est illustrée ci-dessous par des exemples qui n'en limitent cependant pas la portée. Ces exemples portent sur un type de traitement plasma et sur la mesure du taux d'oxygène dans l'enceinte de confinement.

### Exemple 1 : Mesure de l'efficacité du traitement avec et sans rouleau presseur

On utilise une installation telle que celle décrite aux figures 1 à 3. Cette installation comprend :
- Un tambour 1 dont le diamètre est 400 mm
- Un rouleau presseur 2 dont le diamètre est 100 mm
- Sept blocs de traitement identiques, tels celui 3A. Chacun possède des orifices d'injection 37 d'une surface de 400 mm².

Les dimensions caractéristiques de l'installation sont les suivantes :
- Distance d1= 1 mm
- Distance d2 = 4 mm
- Distance d3 = 12 mm
- Distance d4 = 1 mm
- Distance d5 = 5 mm.

On fait défiler, à une vitesse de 400 mètres par minute, un film de BOPP, dont la largeur est 550 mm et dont l'épaisseur est de 20 µm. On utilise, en tant que gaz plasmagène, de l'azote N₂

L'énergie de surface obtenue est mesurée après traitement avec des encres tests calibrées suivant la norme ASTM D-2578. Avant traitement le film a une énergie de surface de 30 mN/m.
* Dans une première mise en œuvre, conforme à l'invention, on injecte le gaz plasmagène à des débits respectifs de 50 m³/h. Cette configuration a conduit à une énergie de surface de 58 mN/m.
* On a ensuite réalisé, à titre comparatif, une seconde mise en oeuvre, qui n'est pas conforme à l'invention. A cet effet, on n'a pas utilisé de rouleau presseur. Cette configuration a conduit à une énergie de surface de 44 mN/m.

### Exemple 2 : Mesure de l'inertage de l'enceinte de confinement avec et sans rouleau presseur à différentes vitesses de défilement

On utilise la même installation que celle de l'exemple 1 ci-dessus. De l'azote est injecté dans les sept blocs successifs sur une largeur de 200 mm à un débit total de 25 m³/h. Le taux d'oxygène est mesuré dans l'enceinte de confinement au-dessus des blocs.

A partir d'une certaine vitesse, dans l'exemple (300 m/min), la quantité d'azote injectée n'est plus suffisante pour compenser l'apport d'oxygène entrainé par le défilement du film et la proportion d'oxygène augmente. Lorsque le rouleau presseur 2 (ou « Nip ») est utilisé conformément à l'invention, l'effet de lamination de l'oxygène en entrée permet d'augmenter la vitesse en gardant un niveau d'oxygène acceptable pour le traitement plasma sans augmenter le débit d'azote.

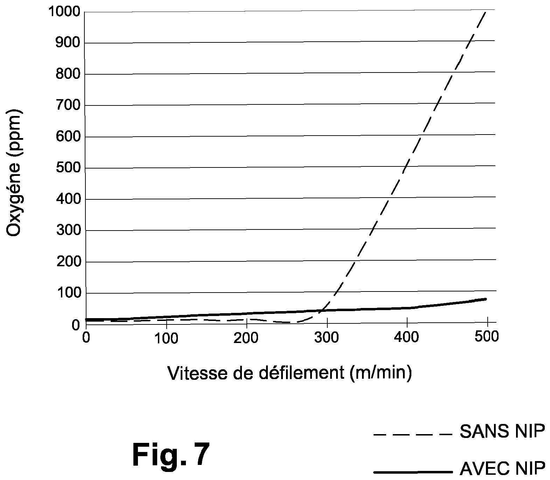

Les variations du taux d'oxygène dans l'enceinte de confinement, en fonction de la vitesse de défilement du substrat, sont illustrées sur la figure 7 annexée. Sur cette figure, la courbe pleine illustre cette variation avec l'utilisation d'un rouleau presseur selon l'invention, alors que la courbe pointillée illustre cette variation en l'absence d'un tel rouleau.

## Revendications

1. Installation de traitement de surface d'un substrat (SUB) en mouvement, comprenant
- un support (1 ; 101 ; 201) pour le substrat,
- un rouleau presseur (2 ; 102 ; 202), apte à presser le substrat contre ledit support
- un ensemble de traitement placé en aval du rouleau presseur, en référence au défilement du substrat, ledit ensemble comprenant
✔ des moyens d'injection (37 ; 137,137',137" ; 237,237') pour l'injection d'un gaz de traitement vers ledit support ;
✔ des moyens (8 ; 108,108',108" ; 208,208') de transformation de la surface du substrat en mouvement ;
**caractérisée en ce que** cette installation comprend en outre
- un capot de confinement (4 ; 104 ; 204), ouvert en direction du support, ledit capot de confinement (4; 104 ; 204) étant distinct dudit ensemble de traitement, ce capot et ce support définissant un volume intérieur dans lequel est reçu ledit ensemble de traitement, ce capot comprenant une paroi frontale dite amont (42 ; 142 ; 242), tournée vers ledit rouleau presseur, le bord d'extrémité (42' ; 142' ; 242') de ladite paroi frontale amont (42 ; 142 ; 242) étant positionné au voisinage dudit rouleau presseur (2 ; 102 ; 202) ; et
- des moyens de recyclage (5 ; 37B ; 137B ; 237') d'une partie du gaz de traitement vers l'amont desdits moyens d'injection,
de manière à définir un volume de recirculation (VR) de gaz de traitement, délimité par le bord d'extrémité de ladite paroi frontale amont, le rouleau presseur, le support et l'extrémité amont de l'ensemble de traitement,
- la plus petite distance (d2) entre le bord d'extrémité (42' ; 142' ; 242') de ladite paroi frontale amont (42 ; 142 ; 242) et le rouleau presseur (2 ; 102 ; 202) étant inférieure à 15 millimètres,
- la plus petite distance (d3) entre ladite paroi frontale amont (42 ; 142 ; 242) et l'ensemble de traitement étant inférieure à 20 millimètres ; et
- la plus petite distance (d5) entre le rouleau presseur (2) et l'ensemble de traitement étant inférieure à 10 millimètres.

2. Installation selon la revendication 1, **caractérisée en ce que** la plus petite distance (d2) entre le bord d'extrémité (42' ; 142' ; 242') de ladite paroi frontale amont (42 ; 142 ; 242) et le rouleau presseur (2 ; 102 ; 202) est inférieure à 5 millimètres.

3. Installation selon l'une des revendications précédentes, **caractérisée en ce que** la plus petite distance (d3) entre ladite paroi frontale amont (42 ; 142 ; 242) et l'ensemble de traitement est inférieure à 2 millimètres.

4. Installation selon l'une des revendications précédentes, **caractérisée en ce que** la plus petite distance (d1) entre l'extrémité amont de l'ensemble de traitement et le support (1 ; 101 ; 201) est inférieure à 5 millimètres, de préférence inférieure à 2 millimètres.

5. Installation selon l'une des revendications précédentes, **caractérisée en ce que** la plus petite distance (d5) entre le rouleau presseur (2) et l'ensemble de traitement est inférieure à 5 millimètres.

6. Installation selon l'une des revendications précédentes, **caractérisée en ce que** les moyens d'injection comprennent au moins un premier organe d'injection (37 ; 137 ; 237) et **en ce que** les moyens de recyclage du gaz de traitement comprennent au moins un déflecteur mécanique (5), placé en aval dudit premier organe d'injection.

7. Installation selon l'une des revendications 1 à 5, **caractérisée en ce que** les moyens d'injection comprennent au moins un premier organe d'injection (37 ; 137 ; 237) et **en ce que** les moyens de recyclage du gaz de traitement comprennent au moins un deuxième organe d'injection (37B ; 137B ; 237') placé en aval dudit premier organe d'injection.

8. Installation selon l'une des revendications précédentes, **caractérisée en ce qu'**il est prévu un chemin de renvoi (6 ; 106 ; 206) du gaz de traitement, dans lequel ledit gaz s'écoule sensiblement radialement vers l'extérieur en référence au support, ce chemin de renvoi étant prévu en amont des moyens de recyclage (5 ; 37B ; 137B ; 237').

9. Installation selon les revendications 4 et 8, **caractérisée en ce que** ce chemin de renvoi présente une section (d4) comprise entre (d1) et 10 mm, de préférence entre (d1) et 2*(d1), où (d1) est la plus petite distance entre l'extrémité amont de l'ensemble de traitement et le support.

10. Installation selon l'une des revendications précédentes, **caractérisée en ce que** ledit ensemble de traitement comprend au moins un bloc massif (3A - 3D) dans lequel sont percés des orifices de sortie (37) du gaz de traitement, l'extrémité amont du bloc amont définissant l'extrémité amont de l'ensemble de traitement, un logement de réception d'au moins une électrode étant en outre ménagé dans ce bloc massif.

11. Installation selon la revendication 10, **caractérisée en ce que** l'ensemble de traitement comprend plusieurs blocs massifs placés les uns derrière les autres selon la direction de défilement du substrat, les extrémités en regard des deux blocs adjacents les plus amont définissant ledit chemin de renvoi.

12. Installation selon l'une des revendications 1 à 9, **caractérisée en ce que** l'ensemble de traitement comprend au moins une tête (103A, 103B), définissant un volume intérieur (V103) ouvert en direction du support, ladite tête comprenant une paroi latérale amont dont le bord d'extrémité définit l'extrémité amont de l'ensemble de traitement.

13. Installation selon l'une des revendications 1 à 9, **caractérisée en ce que**
- l'ensemble de traitement comprend une succession d'organes d'injection de gaz (237, 237') et d'électrodes (208, 208') directement fixés sur le capot de confinement, l'organe d'injection amont définissant l'extrémité amont de l'ensemble de traitement.

14. Procédé de dimensionnement d'une installation de traitement de surface d'un substrat (SUB) en mouvement, ladite installation comprenant
- un support (1 ; 101 ; 201) pour le substrat,
- un rouleau presseur (2 ; 102 ; 202), apte à presser le substrat contre ledit support
- un ensemble de traitement placé en aval du rouleau presseur, en référence au défilement du substrat, ledit ensemble comprenant
✔ des moyens d'injection (37 ; 137,137',137" ; 237,237') pour l'injection d'un gaz de traitement vers ledit support ;
✔ des moyens (8 ; 108,108',108" ; 208,208') de transformation de la surface du substrat en mouvement ;
**caractérisé en ce qu'**on fournit en outre
- un capot de confinement (4 ; 104 ; 204), ouvert en direction du support, ledit capot de confinement (4; 104; 204) étant distinct dudit ensemble de traitement, ce capot et
ce support définissant un volume intérieur dans lequel est reçu ledit ensemble de traitement, ce capot comprenant une paroi frontale dite amont (42 ; 142 ; 242), tournée vers ledit rouleau presseur, et
- des moyens de recyclage (5 ; 37B ; 137B ; 237') d'une partie du gaz de traitement vers l'amont desdits moyens d'injection,
et on positionne le bord d'extrémité (42' ; 142' ; 242') de ladite paroi frontale amont (42 ; 142 ; 242) au voisinage dudit rouleau presseur (2 ; 102 ; 202) de manière à définir un volume de recirculation (VR) de gaz de traitement, délimité par le bord d'extrémité de ladite paroi frontale amont, le rouleau presseur, le support et l'extrémité amont de l'ensemble de traitement,
- la plus petite distance (d2) entre le bord d'extrémité (42'; 142'; 242') de ladite paroi frontale amont (42; 142; 242) et le rouleau presseur (2; 102; 202) étant inférieure à 15 millimètres,
- la plus petite distance (d3) entre ladite paroi frontale amont (42; 142; 242) et l'ensemble de traitement étant inférieure à 20 millimètres, et
- la plus petite distance (d5) entre le rouleau presseur (2) et l'ensemble de traitement étant inférieure à 10 millimètres.

## Patentansprüche

1. Anlage zur Behandlung der Oberfläche eines beweglichen Substrats (SUB), umfassend
- einen Träger (1; 101; 201) für das Substrat,
- eine Andrückwalze (2; 102; 202), die imstande ist, das Substrat gegen den Träger zu drücken,
- eine Behandlungseinheit, die stromabwärts von der Andrückwalze angeordnet ist, Bezug nehmend auf die Laufrichtung des Substrats, wobei die Einheit umfasst
✔ Einspritzmittel (37; 137, 137', 137"; 237, 237') für die Einspritzung eines Behandlungsgases in Richtung Träger;
✔ Mittel (8; 108, 108', 108"; 208, 208') zur Transformation der Oberfläche des beweglichen Substrats;
**dadurch gekennzeichnet, dass** diese Anlage weiter umfasst
- eine Schutzabdeckung (4; 104; 204), die in Richtung des Trägers offen ist, wobei die Schutzabdeckung (4; 104; 204) von der Behandlungseinheit verschieden ist, wobei diese Abdeckung und dieser Träger ein Innenvolumen definieren, in dem die Behandlungseinheit aufgenommen ist, wobei diese Abdeckung eine so genannte stromaufwärtige Vorderwand (42; 142; 242) umfasst, die zur Andrückwalze gerichtet ist, wobei die Endkante (42'; 142'; 242') der stromaufwärtigen Vorderwand (42; 142; 242) in der Nähe der Andrückwalze (2; 102; 202) positioniert ist; und
- Recyclingmittel (5; 37B; 137B; 237') eines Teils des Behandlungsgases in Richtung Stromaufwärtsseite der Einspritzmittel,
sodass ein Volumen zur Rückführung (VR) des Behandlungsgases definiert wird, das von der Endkante der stromaufwärtigen Vorderwand, der Andrückwalze, dem Träger und dem stromaufwärtigen Ende der Behandlungseinheit begrenzt wird,
- wobei die kleinste Distanz (d2) zwischen der Endkante (42'; 142'; 242') der stromaufwärtigen Vorderwand (42; 142; 242) und der Andrückwalze (2; 102; 202) kleiner als 15 Millimeter ist,
- wobei die kleinste Distanz (d3) zwischen der stromaufwärtigen Vorderwand (42; 142; 242) und der Behandlungseinheit kleiner als 20 Millimeter ist; und
- wobei die kleinste Distanz (d5) zwischen der Andrückwalze (2) und der Behandlungseinheit kleiner als 10 Millimeter ist.

2. Anlage nach Anspruch 1, **dadurch gekennzeichnet, dass** die kleinste Distanz (d2) zwischen der Endkante (42'; 142'; 242') der stromaufwärtigen Vorderwand (42; 142; 242) und der Andrückwalze (2; 102; 202) kleiner als 5 Millimeter ist.

3. Anlage nach einem der vorstehenden Ansprüche, **dadurch gekennzeichnet, dass** die kleinste Distanz (d3) zwischen der stromaufwärtigen Vorderwand (42; 142; 242) und der Behandlungseinheit kleiner als 2 Millimeter ist.

4. Anlage nach einem der vorstehenden Ansprüche, **dadurch gekennzeichnet, dass** die kleinste Distanz (d1) zwischen dem stromaufwärtigen Ende der Behandlungseinheit und dem Träger (1; 101; 201) kleiner als 5 Millimeter ist, vorzugsweise kleiner als 2 Millimeter.

5. Anlage nach einem der vorstehenden Ansprüche, **dadurch gekennzeichnet, dass** die kleinste Distanz (d5) zwischen der Andrückwalze (2) und der Behandlungseinheit kleiner als 5 Millimeter ist.

6. Anlage nach einem der vorstehenden Ansprüche, **dadurch gekennzeichnet, dass** die Einspritzmittel wenigstens ein erstes Einspritzelement (37; 137; 237) umfassen, und dadurch, dass die Recyclingmittel des Behandlungsgases wenigstens einen mechanischen Ablenker (5) umfassen, der stromabwärts von dem ersten Einspritzelement angeordnet ist.

7. Anlage nach einem der Ansprüche 1 bis 5, **dadurch gekennzeichnet, dass** die Einspritzmittel wenigstens ein erstes Einspritzelement (37; 137; 237) umfassen, und dadurch, dass die Recyclingmittel des Behandlungsgases wenigstens ein zweites Einspritzelement (37B; 137B; 237') umfassen, das stromabwärts von dem ersten Einspritzelement angeordnet ist.

8. Anlage nach einem der vorstehenden Ansprüche, **dadurch gekennzeichnet, dass** ein Umlenkweg (6; 106; 206) des Behandlungsgases vorgesehen ist, in dem das Gas im Wesentlichen radial nach außen, Bezug nehmend auf den Träger, abfließt, wobei dieser Umlenkweg stromaufwärts von den Recyclingmitteln (5; 37B; 137B; 237') vorgesehen ist.

9. Anlage nach den Ansprüchen 4 und 8, **dadurch gekennzeichnet, dass** dieser Umlenkweg einen Querschnitt (d4) aufweist, der zwischen (d1) und 10 mm beträgt, vorzugsweise zwischen (d1) und 2*(d1), wobei (d1) die kleinste Distanz zwischen dem stromaufwärtigen Ende der Behandlungseinheit und dem Träger ist.

10. Anlage nach einem der vorstehenden Ansprüche, **dadurch gekennzeichnet, dass** die Behandlungseinheit wenigstens einen Massivblock (3A-3D) umfasst, in den Austrittsöffnungen (37) des Behandlungsgases gebohrt sind, wobei das stromaufwärtige Ende des stromaufwärtigen Blocks das stromaufwärtige Ende der Behandlungseinheit definiert, wobei eine Aussparung zur Aufnahme wenigstens einer Elektrode weiter in diesem Massivblock eingerichtet ist.

11. Anlage nach Anspruch 10, **dadurch gekennzeichnet, dass** die Behandlungseinheit mehrere Massivblöcke umfasst, die hintereinander gemäß der Laufrichtung des Substrats angeordnet sind, wobei die gegenüberliegenden Enden der zwei stromaufwärtigsten benachbarten Blöcke den Umlenkweg definieren.

12. Anlage nach einem der Ansprüche 1 bis 9, **dadurch gekennzeichnet, dass** die Behandlungseinheit wenigstens einen Kopf (103A, 103B) umfasst, der ein in Richtung des Trägers offenes Innenvolumen (V103) definiert, wobei der Kopf eine stromaufwärtige Seitenwand umfasst, deren Endkante das stromaufwärtige Ende der Behandlungseinheit definiert.

13. Anlage nach einem der Ansprüche 1 bis 9, **dadurch gekennzeichnet, dass**
- die Behandlungseinheit eine Aufeinanderfolge von Gaseinspritzelementen (237, 237') und von Elektroden (208, 208') umfasst, die direkt auf der Schutzabdeckung befestigt sind, wobei das stromaufwärtige Einspritzelement das stromaufwärtige Ende der Behandlungseinheit definiert.

14. Verfahren zur Bestimmung der Größe einer Anlage zur Behandlung der Oberfläche eines beweglichen Substrats (SUB), wobei die Anlage umfasst
- einen Träger (1; 101; 201) für das Substrat,
- eine Andrückwalze (2; 102; 202), die imstande ist, das Substrat gegen den Träger zu drücken,
- eine Behandlungseinheit, die stromabwärts von der Andrückwalze angeordnet ist, Bezug nehmend auf die Laufrichtung des Substrats, wobei die Einheit umfasst
✔ Einspritzmittel (37; 137, 137', 137"; 237, 237') für die Einspritzung eines Behandlungsgases in Richtung Träger;
✔ Mittel (8; 108, 108', 108"; 208, 208') zur Transformation der Oberfläche des beweglichen Substrats;
**dadurch gekennzeichnet, dass** weiter bereitgestellt wird
- eine Schutzabdeckung (4; 104; 204), die in Richtung des Trägers offen ist, wobei die Schutzabdeckung (4; 104; 204) von der Behandlungseinheit verschieden ist, wobei diese Abdeckung und dieser Träger ein Innenvolumen definieren, in dem die Behandlungseinheit aufgenommen ist, wobei diese Abdeckung eine so genannte stromaufwärtige Vorderwand (42; 142; 242) umfasst, die zur Andrückwalze gerichtet ist, und
- Recyclingmittel (5; 37B; 137B; 237') eines Teils des Behandlungsgases in Richtung Stromaufwärtsseite der Einspritzmittel,
und die Endkante (42'; 142'; 242') der stromaufwärtigen Vorderwand (42; 142; 242) in der Nähe der Andrückwalze (2; 102; 202) positioniert wird, sodass ein Volumen zur Rückführung (VR) des Behandlungsgases definiert wird, das von der Endkante der stromaufwärtigen Vorderwand, der Andrückwalze, dem Träger und dem stromaufwärtigen Ende der Behandlungseinheit begrenzt wird,
- wobei die kleinste Distanz (d2) zwischen der Endkante (42'; 142'; 242') der stromaufwärtigen Vorderwand (42; 142; 242) und der Andrückwalze (2; 102; 202) kleiner als 15 Millimeter ist,
- wobei die kleinste Distanz (d3) zwischen der stromaufwärtigen Vorderwand (42; 142; 242) und der Behandlungseinheit kleiner als 20 Millimeter ist, und
- wobei die kleinste Distanz (d5) zwischen der Andrückwalze (2) und der Behandlungseinheit kleiner als 10 Millimeter ist.

## Claims

1. Facility for treating the surface of a moving substrate (SUB), comprising
- a support (1; 101; 201) for the substrate,
- a pressing roll (2; 102; 202) able to press the substrate against said support
- a treatment unit positioned downstream of the pressing roll, with reference to the direction of travel of the substrate, said unit comprising
-- injection means (37; 137, 137', 137"; 237, 237') for injecting a treatment gas towards said support;
-- means (8; 108, 108', 108"; 208, 208') for transforming the surface of the moving substrate;
**characterized in that** this facility further comprises
- a containment cover (4; 104; 204) open in the direction of the support, said containment cover (4; 104; 204) being distinct from said treatment unit, this cover and this support defining an inner volume in which said treatment unit is received, this cover comprising a front wall called the upstream wall (42; 142; 242), facing towards said pressing roll, the end edge (42'; 142'; 242') of said upstream front wall (42; 142; 242) being positioned in the vicinity of said pressing roll (2; 102; 202); and
- means (5; 37B; 137B; 237') for recirculating some of the treatment gas upstream of said injection means,
so as to define a recirculation volume (VR) for the treatment gas, defined by the end edge of said upstream front wall, the pressing roll, the support and the upstream end of the treatment unit,
- the smallest distance (d2) between the end edge (42'; 142'; 242') of said upstream front wall (42; 142; 242) and the pressing roll (2; 102; 202) being less than 15 millimeters,
- the smallest distance (d3) between said upstream front wall (42; 142; 242) and the treatment unit being less than 20 millimeters, and
- the smallest distance (d5) between the pressing roll (2) and the treatment unit being less than 10 millimeters.

2. Facility according to claim 1, **characterized in that** the smallest distance (d2) between the end edge (42'; 142'; 242') of said upstream front wall (42; 142; 242) and the pressing roll (2; 102; 202) is less than 5 millimeters.

3. Facility according to any of the preceding claims, **characterized in that** the smallest distance (d3) between said upstream front wall (42; 142; 242) and the treatment unit is less than 2 millimeters.

4. Facility according to any of the preceding claims, **characterized in that** the smallest distance (d1) between the upstream end of the treatment unit and the support (1; 101; 201) is less than 5 millimeters, preferably less than 2 millimeters.

5. Facility according to any of the preceding claims, **characterized in that** the smallest distance (d5) between the pressing roll (2) and the treatment unit is less than 5 millimeters.

6. Facility according to any of the preceding claims, **characterized in that** the injection means comprise at least one first injection member (37; 137; 237) and **in that** the means for recirculating the treatment gas comprise at least one mechanical deflector (5), placed downstream of said first injection member.

7. Facility according to any of claims 1 to 5, **characterized in that** the injection means comprise at least one first injection member (37; 137; 237) and **in that** the means for recirculating the treatment gas comprise at least one second injection member (37B, 137B, 237') placed downstream of said first injection member.

8. Facility according to any of the preceding claims, **characterized in that** a pathway (6; 106; 206) for returning the treatment gas is provided, in which said gas flows substantially radially towards the outside with reference to the support, this return pathway being provided upstream of the recirculation means (5; 37B; 137B; 237').

9. Facility according to claims 4 and 8, **characterized in that** this return pathway has a cross-section (d4) lying between (d1) and 10 mm, preferably between (d1) and 2*(d1), where (d1) is the smallest distance between the upstream end of the treatment unit and the support.

10. Facility according to any of the preceding claims, **characterized in that** said treatment unit comprises at least one solid block (3A-3D) in which outlet orifices (37) for the treatment gas are pierced, the upstream end of the upstream block defining the upstream end of the treatment unit, a housing for receiving at least one electrode furthermore being provided in this solid block.

11. Facility according to claim 10, **characterized in that** the treatment unit comprises a plurality of solid blocks placed one behind the other in the direction of travel of the substrate, the facing ends of the two most upstream adjacent blocks defining said return pathway.

12. Facility according to any of claims 1 to 9, **characterized in that** the treatment unit comprises at least one head (103A, 103B) defining an internal volume (V103) open in the direction of the support, said head comprising an upstream lateral wall the end edge of which defines the upstream end of the treatment unit.

13. Facility according to any of claims 1 to 9, **characterized in that**
- the treatment unit comprises a succession of gas-injection members (237, 237') and electrodes (208, 208') directly fixed to the containment cover, the upstream injection member defining the upstream end of the treatment unit.

14. Method for sizing a facility for the surface treatment of a moving substrate (SUB), said facility comprising
- a support (1; 101; 201) for the substrate,
- a pressing roll (2; 102; 202) able to press the substrate against said support
- a treatment unit positioned downstream of the pressing roll, with reference to the direction of travel of the substrate, said unit comprising
-- injection means (37; 137, 137', 137"; 237, 237') for injecting a treatment gas towards said support;
-- means (8; 108, 108', 108"; 208, 208') for transforming the surface of the moving substrate;
**characterized in that** the following are also provided
- a containment cover (4; 104; 204) open in the direction of the support, said containment cover (4; 104; 204) being distinct from said treatment unit, this cover and this support defining an inner volume in which said treatment unit is received, this cover comprising a front wall called the upstream wall (42; 142; 242), facing towards said pressing roll, and
- means (5; 37B; 137B; 237') for recirculating some of the treatment gas upstream of said injection means,
and the end edge (42'; 142'; 242') of said upstream front wall (42; 142; 242) is positioned in the vicinity of said pressing roll (2; 102; 202) so as to define a volume (VR) for recirculation of the treatment gas, delimited by the end edge of said upstream front wall, the pressing roll, the support and the upstream end of the treatment unit,
- the smallest distance (d2) between the end edge (42'; 142'; 242') of said upstream front wall (42; 142; 242) and the pressing roll (2; 102; 202) being less than 15 millimeters,
- the smallest distance (d3) between said upstream front wall (42; 142; 242) and the treatment unit being less than 20 millimeters, and
- the smallest distance (d5) between the pressing roll (2) and the treatment unit being less than 10 millimeters.
